# EUROPEAN PATENT APPLICATION

(11) **EP 4 780 179 A1**
(43) Date of publication of application: **22.07.2026**
(21) Application number: 25222408.4
(22) Date of filing: 10.12.2025
(51) Int. Cl.: H10K 59/35, H10K 59/80

(54) **DISPLAY PANEL AND VEHICLE**

(30) Priority: 21.01.2025 KR 20250009046
(71) Applicant: LG Display Co., Ltd., Seoul, 07336 (KR)
(72) Inventor: JIN, You Yong, Paju-si (KR); LEE, Dae Heung, Paju-si (KR); OH, Se Wan, Paju-si (KR)
(74) Representative: Finlayson, Scott Henry

(57) **Abstract**

A display apparatus presented herein includes pixel lenses. The pixel lenses is disposed on pixel areas of a device substrate. An upper barrier pattern is disposed between the device substrate and the pixel lenses. The upper barrier pattern includes upper openings overlapping with the pixel lenses. Each of the pixel areas includes a first emission area and a second emission area, which are disposed side by side. The pixel lens of each pixel lens includes a lens central point disposed between the first emission area and the second emission area of the corresponding pixel area. Each of the first emission area and the second emission area includes a first region overlapping with the corresponding upper opening and a second region disposed outside the upper openings. Thus, the quality of an image generated by the display apparatus and shared with users located in different directions is improved.

## Description

### CROSS-REFERENCE TO RELATED APPLICATION

The present application claims priority to Republic of Korea Patent Application No. 10-2025-0009046, filed on January 21, 2025, which is hereby incorporated by reference in its entirety.

### BACKGROUND

### Field

The present disclosure relates to a display panel, and particularly, for example, without limitation, to a display panel in which pixel lenses are disposed on pixel areas of a device substrate, and a vehicle comprising the same.

### Discussion of Related Art

Generally, a display apparatus provides an image to a user. For example, the display apparatus can include light-emitting devices. Each of the light-emitting devices can emit light displaying a specific color. For example, each of the light-emitting devices can include a light-emitting unit disposed between a first electrode and a second electrode.

For example, pixel lenses can be disposed on the light-emitting devices. For example, light emitted from each light-emitting device can travel toward the user through one of the pixel lenses. Thus, in the display apparatus, the quality of the image can be improved.

The description provided in the background section should not be assumed to be prior art merely because it is mentioned in or associated with the background section. The background section may include information that describes one or more aspects of the subject technology.

### SUMMARY

Accordingly, the present disclosure is directed to a display apparatus that substantially obviates one or more problems due to limitations and disadvantages of the related art.

An object of the present disclosure is to provide a display device capable of improving the quality of an image shared with users located in different directions.

An object of the present disclosure is to provide a display device capable of increasing the luminance of light travelling in a direction between the users sharing the image.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these objects and other advantages and in accordance with the purpose of the present disclosure, as embodied and broadly described herein, there is provided a display apparatus comprising a device substrate. A bank insulating layer is disposed on the device substrate. The bank insulating layer defines a first emission area and a second emission area in a pixel area. The second emission area is disposed side by side with the first emission area in a first direction. An upper barrier pattern is disposed on the bank insulating layer. The upper barrier pattern includes an upper opening overlapping with the pixel area. A pixel lens is disposed on the upper barrier pattern. The pixel lens overlaps the upper opening. A lens central point of the pixel lens is disposed between the first emission area and the second emission. Each of the first emission area and the second emission area includes a first side surface and a second side surface. The first side surface and the second side surface of each emission area extend in a second direction perpendicular to the first direction. The second side surface of each emission area is disposed between the lens central point and the first side surface of the corresponding emission area. The second side surface of each emission area has a longer length than the first side surface of the corresponding emission area.

The first side surface of the first emission area and the first side surface of the second emission area can be disposed outside the upper opening. The second side surface of the first emission area and the second side surface of the second emission area can overlap the upper opening.

A shape of the second emission area can be symmetrical to a shape of the first emission area with respect to a virtual center line passing through the lens central point in the second direction.

The second emission area can have a same size as the first emission area.

The lens central point can be disposed within the upper opening. The upper opening can have a symmetric shape with respect to the lens central point.

A lower surface of the pixel lens toward the device substrate can have a larger size than the upper opening.

A lower barrier pattern can be disposed between the bank insulating layer and the upper barrier pattern. The lower barrier pattern can include a lower opening. The lower opening can overlap the upper opening and the pixel lens. The lower opening can have a symmetric shape with respect to the lens central point.

A size of the upper opening can be smaller than a size of the lower opening.

A device planarization layer can be disposed between the device substrate and the bank insulating layer. The device planarization layer can overlap the first emission area and the second emission area. A first light-emitting device and a second light-emitting device can be disposed between the device planarization layer and the upper barrier pattern. The first light-emitting device can overlap the first emission area. The second light-emitting device can overlap the second emission area. A first driving circuit and a second driving circuit can be disposed between the device substrate and the device planarization layer. The first light-emitting device can be electrically connected to the first driving circuit. The second light-emitting device can be electrically connected to the second driving circuit. The second driving circuit can be insulated from the first driving circuit.

The configuration of the second driving circuit can be a same as the configuration of the first driving circuit.

In one or more other embodiments, there is provided a display apparatus comprising a device substrate. The device substrate includes pixel areas. An upper barrier pattern is disposed on the device substrate. The upper barrier pattern includes upper openings overlapping with the pixel areas. Pixel lenses are disposed on the upper barrier pattern. Each of the pixel lenses overlaps one of the upper openings. Each of the pixel areas includes a first emission area and a second emission area. The second emission area is disposed side by side with the first emission area in a first direction. Each of the first emission area and the second emission area includes a first region and a second region. The first region of each emission area overlaps the upper barrier pattern. The second region of each emission area overlaps one of the upper openings. The first region of each emission area has a smaller size than the second region of the corresponding emission area.

The first region of the second emission area can have a different size than the first region of the first emission area. The second region of the second emission area can have a different size than the second region of the first emission area.

The pixel areas can include a first pixel area, a second pixel area, a third pixel area and a fourth pixel area. The second pixel area can be disposed side by side with the first pixel area in the first direction. The third pixel area can be disposed side by side with the first pixel area in a second direction perpendicular to the first direction. The fourth pixel area can be disposed side by side with the first pixel area in a direction inclined to the first direction and the second direction. A distance between the first pixel area and the third pixel area in the second direction can be a same as a distance between the first pixel area and the second pixel area in the first direction. A distance between the first pixel area and the fourth pixel area in a direction inclined to the first direction and the second direction can be smaller than the distance between the first pixel area and the third pixel area in the second direction.

The second pixel area can display a different color from the first pixel area. The third pixel area can display a same color as the first pixel area. The fourth pixel area can display a different color from the first pixel area and the second pixel area.

The second region of each emission area can have a same length as the first region of the corresponding emission area.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the present disclosure and are incorporated in and constitute a part of this disclosure, illustrate embodiment(s) of the present disclosure and together with the description serve to explain the principle of the present disclosure. In the drawings:
FIG. 1 is a view schematically showing a location where a display apparatus is installed according to one or more embodiments of the present disclosure.
FIG.2 is a view showing a plane of a display panel in the display apparatus according to one or more embodiments of the present disclosure.
FIG. 3 is an enlarged view of K1 region in FIG. 2.
FIG. 4 is a view showing a driving circuit of a sub-pixel in a display panel of the display apparatus according to one or more embodiments of the present disclosure.
FIG. 5 is a view taken along I-I' of FIG. 3;
FIG. 6 illustrate graphs showing luminance according to a viewing angle in a comparison display apparatus in which opposite side surfaces of each emission area have a same length and in the display apparatus according to one or more embodiments of the present disclosure.
FIGS. 7 to 13 are views showing the display apparatus according to one or more other embodiments of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Hereinafter, details related to the above objects, technical configurations, and operational effects of the embodiments of the present disclosure will be clearly understood by the following detailed description with reference to the drawings, which illustrate some embodiments of the present disclosure. Here, the embodiments of the present disclosure are provided in order to allow the technical sprit of the present disclosure to be satisfactorily transferred to those skilled in the art, and thus the present disclosure may be embodied in other forms and is not limited to the embodiments described below.

In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure, and implementation methods thereof will be clarified through following example embodiments described with reference to the accompanying drawings. The present disclosure may, however, be embodied in different forms and should not be construed as limited to example embodiments set forth herein. Rather, these example embodiments may be provided so that this disclosure may be sufficiently thorough and complete to assist those skilled in the art to fully understand the scope of the present disclosure. Further, the present disclosure is only defined by scopes of claims.

The shapes (e.g., sizes, lengths, widths, heights, thicknesses, locations, radii, diameters, and areas), ratios, angles, numbers, and the like, which are illustrated in the drawings to describe various example embodiments of the present disclosure are merely given by way of example. Therefore, the present disclosure is not limited to the illustrations in the drawings.

In addition, the same or extremely similar elements may be designated by the same reference numerals throughout the specification and in the drawings, the lengths and thickness of layers and regions may be exaggerated for convenience. It will be understood that, when a first element is referred to as being "on" a second element, although the first element may be disposed on the second element so as to come into contact with the second element, a third element may be interposed between the first element and the second element.

Here, terms such as, for example, "first," "second," "A," "B," "(a)," and "(b)," etc. may be used to distinguish any one element with another element. However, the first element and the second element may be arbitrary named according to the convenience of those skilled in the art without departing the technical sprit of the present disclosure.

The word "exemplary" is used to mean serving as an example or illustration. Aspects are example aspects. "Embodiments," "examples," "aspects," and the like should not be construed as preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

The term "at least one" should be understood as including any and all combinations of one or more of the associated listed items. For example, the meaning of "at least one of a first element, a second element, and a third element" compasses the combination of all three listed elements, combinations of any two of the three elements, as well as each individual element, the first element, the second element, or the third element.

Features of various embodiments of the present disclosure may be partially or overall coupled to or combined with each other, and may be variously inter-operated with each other and driven technically as those skilled in the art can sufficiently understand. Embodiments of the present disclosure may be carried out independently from each other, or may be carried out together in co-dependent relationship.

The terms used in the specification of the present disclosure are merely used in order to describe particular embodiments, and are not intended to limit the scope of the present disclosure. For example, an element described in the singular form is intended to include a plurality of elements unless the context clearly indicates otherwise. In addition, in the specification of the present disclosure, it will be further understood that the terms "comprises" and "includes" specify the presence of stated features, integers, steps, operations, elements, components, and/or combinations thereof, but do not preclude the presence or addition of one or more other features, integers, steps, operations, elements, components, and/or combinations.

And, unless 'directly' is used, the terms "connected" and "coupled" may include that two components are "connected" or "coupled" through one or more other components located between the two components.

The terms, such as "below," "lower," "above," "upper" and the like, may be used herein to describe a relationship between item(s) as illustrated in the drawings. It will be understood that the terms are spatially relative and based on the orientation depicted in the drawings.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

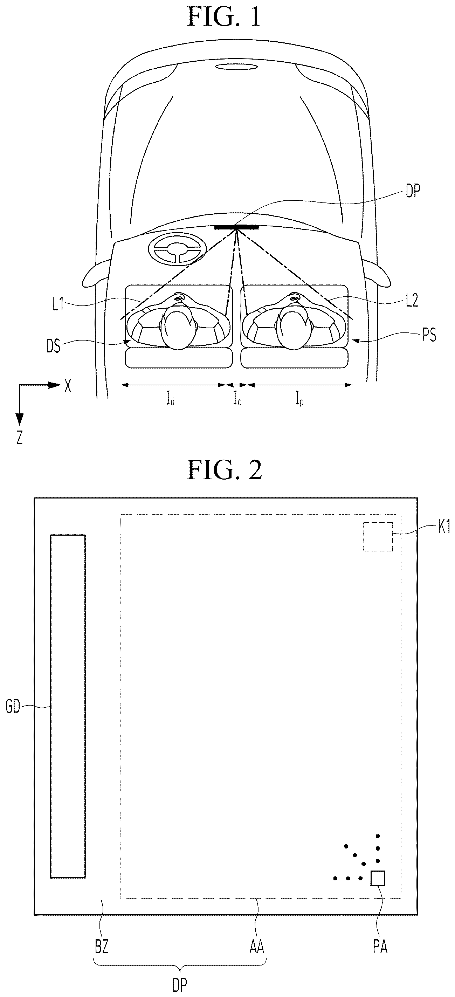

FIG. 1 is a view schematically showing a location where a display apparatus is installed according to one or more embodiments of the present disclosure.

Referring to FIG. 1, the display apparatus according to one or more embodiments of the present disclosure can include a display panel DP disposed in a car. The display panel DP can generate an image. The image realized by the display panel DP can be provided to a driver sitting in a driver seat DS and/or a passenger sitting in a passenger seat PS. For example, the display panel DP can be disposed between the driver seat DS and the passenger seat PS. The driver sitting in the driver seat DS and the passenger sitting in the passenger seat PS can be positioned in a direction inclined in front of the display panel DP.

As an example, the display panel DP can provide the passenger sitting in the passenger seat PS with an image the same as that for the driver sitting in the driver seat DS, or the display panel DP can selectively provide the passenger sitting in the passenger seat PS with an image different from that for the driver sitting in the driver seat DS. For example, the display panel DP can provide a first image containing a first information to the driver sitting in the driver seat DS and a second image containing a second information different from the first information to the passenger sitting in the passenger seat PS. For example, the display panel DP can provide a first image containing information related to the operation of the car to the driver sitting in the driver seat DS and a second image containing information unrelated to the operation of the car to the passenger sitting in the passenger seat PS, when the car is in a moving state, without being limited thereto. The second image can be provided simultaneously with the first image. For example, the first image can be realized by a first light L1 emitted from the display panel DP toward the driver seat DS, and the second image can be realized by a second light L2 emitted from the display panel DP toward the passenger seat PS. Thus, in the display apparatus according to one or more embodiments of the present disclosure, the second image will not be recognized by the driver of the driver seat DS. As an example, in the display apparatus according to one or more embodiments of the present disclosure, gaze dispersion of the driver due to the second image can be reduced or prevented. Therefore, in the display apparatus according to one or more embodiments of the present disclosure, the accidents due to gaze dispersion of the driver while driving the car can be reduced or minimized.

The display panel DP can selectively provide a single image to the driver of the driver seat DS and the passenger of the passenger seat PS. For example, in the display apparatus according to one or more embodiments of the present disclosure, the driver of the driver seat DS and the passenger of the passenger seat PS can share the image realized by the first light L1 and the second light L2, for example, when the car is stopped. However, embodiments of the present disclosure are not limited thereto. As an example, the display panel DP can provide the same image (e.g., an image containing information related to or not related to the operation of the car) to the driver sitting in the driver seat DS and the passenger sitting in the passenger seat PS, even when the car is in a moving state. As an example, the display panel DP can provide different images (e.g., an image containing information related to or not related to the operation of the car) to the driver sitting in the driver seat DS and the passenger sitting in the passenger seat PS, even when the car is stopped.

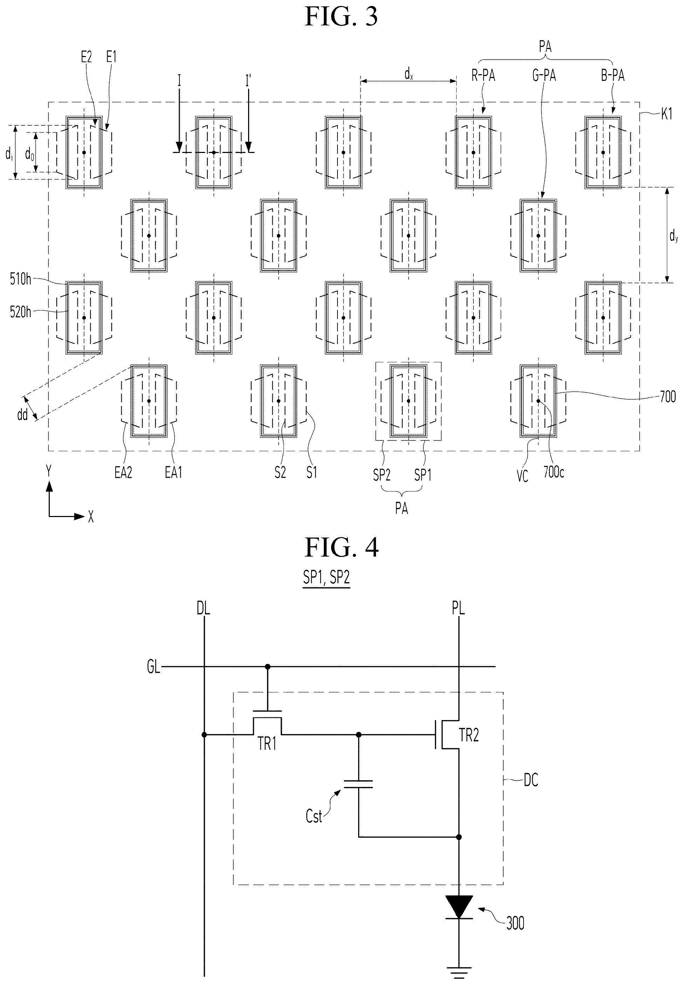

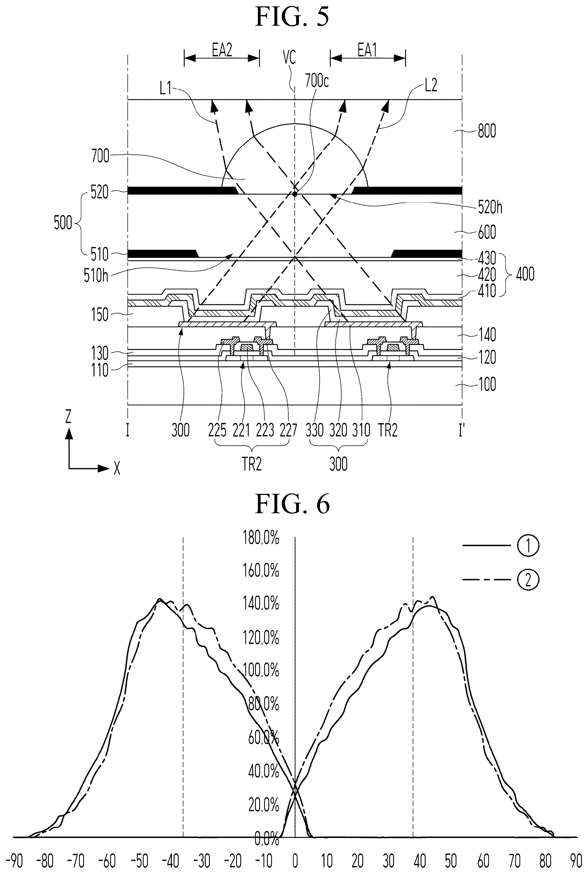

FIG.2 is a view showing a plane of a display panel in the display apparatus according to one or more embodiments of the present disclosure. FIG. 3 is an enlarged view of K1 region in FIG. 2. FIG. 4 is a view showing a driving circuit of a sub-pixel in a display panel of the display apparatus according to one or more embodiments of the present disclosure. FIG. 5 is a view taken along I-I' of FIG. 3.

Referring to FIGS. 1 to 5, the display apparatus according to one or more embodiments of the present disclosure can include pixel areas PA within the display panel DP. As an example, the pixel areas PA can be disposed side by side in a first direction X and a second direction Y perpendicular to the first direction X, or in a direction between the first direction X and the second direction Y, without being limited thereto. Herein, the first direction X can be a direction along which the driver seat DS and the passenger seat PS are arranged. For example, a third direction Z perpendicular to the first direction X and the second direction Y can be a direction in front of the display panel DP.

Each of the pixel areas PA can display a specific color. For example, the pixel area PA can include red pixel areas R-PA realizing a red color, green pixel areas G-PA realizing a green color, and blue pixel areas B-PA realizing a blue color, without being limited thereto. As an example, a pixel area realizing other colors such as white, cyan, yellow and magenta may be additionally or alternatively included. As an example, a first sub-pixel SP1 and a second sub-pixel SP2 can be disposed in each pixel area PA, without being limited thereto. As an example, the second sub-pixel SP2 of each pixel area PA can realize a same color as the first sub-pixel SP1 of the corresponding pixel area PA, without being limited thereto. For example, the first sub-pixel SP1 and the second sub-pixel SP2 of each red pixel area R-PA can realize a red color. As an example, the second sub-pixel SP2 of each pixel area PA can be disposed side by side with the first sub-pixel SP1 of the corresponding pixel area PA in the first direction X, without being limited thereto. For example, the second sub-pixel SP2 of each pixel area PA can be disposed closer to the driver seat DS than the first sub-pixel SP1 of the corresponding pixel area PA, without being limited thereto.

A driving circuit DC electrically connected to signal wirings GL, DL and PL and a light-emitting device 300 electrically connected to the driving circuit DC can be disposed in each sub-pixel SP1 or SP2. The operation of the light-emitting device 300 can be controlled by the driving circuit DC. The signal wirings GL, DL and PL can include a gate line GL applying a gate signal, a data line DL applying a data signal, and a power voltage supply line PL supplying a power voltage. For example, the driving circuit DC can supply a driving current corresponding to the data signal to the light-emitting device 300 according to the gate signal using the power voltage. The driving current supplied to the light-emitting device 300 by the driving circuit DC can be maintained for a certain period (e.g., one frame). For example, the driving circuit DC can include a first thin film transistor TR1, a second thin film transistor TR2 and a storage capacitor Cst. However, embodiments of the present disclosure are not limited thereto. As an example, one or more thin film transistors and one or more capacitors may be additionally included, without being limited thereto.

The first thin film transistor TR1 can transmit the data signal to the second thin film transistor TR2 according to the gate signal. For example, the first thin film transistor TR1 can function as a switching thin film transistor. The first thin film transistor TR1 can include a first semiconductor pattern, a first gate electrode, a first drain electrode and a first source electrode. For example, the first gate electrode can be electrically connected to the gate line GL, and the first drain electrode can be electrically connected to the data line DL.

The second thin film transistor TR2 can generate the driving current according to the data signal using the power voltage. For example, the second thin film transistor TR2 can function as a driving thin film transistor. The second thin film transistor TR2 can include a second semiconductor pattern 221, a second gate electrode 223, a second drain electrode 225 and a second source electrode 227. For example, the second gate electrode 223 can be electrically connected to the first source electrode, and the second drain electrode 225 can be electrically connected to the power voltage supply line PL. The second semiconductor pattern 211 can include a drain region electrically connected to the second drain electrode 225, a source region electrically connected to the second source electrode 227, and a channel region disposed between the drain region and the source region. The channel region of the second semiconductor pattern 221 can overlap the second gate electrode 223. The second gate electrode 223 can be insulated from the second semiconductor pattern 221. For example, the channel region can have an electric conductivity corresponding to a voltage of a signal applied to the second gate electrode 223.

A voltage of the signal applied to the second gate electrode 223 can be maintained for a certain period (e.g., one frame) by the storage capacitor Cst. The storage capacitor Cst can have a stacked structure of capacitor electrodes. For example, the storage capacitor Cst can have a structure in which a first capacitor electrode electrically connected to the second gate electrode 223 and second capacitor electrode electrically connected to the second source electrode 227 are stacked.

As an example, the driving circuit DC of each second sub-pixel SP2 can have a same configuration as the driving circuit DC of each first sub-pixel SP1, without being limited thereto. For example, in the display apparatus according to one or more embodiments of the present disclosure, the driving circuit DC of each second sub-pixel SP2 can be formed simultaneously with the driving circuit DC of each first sub-pixel SP1. Thus, in the display apparatus according to one or more embodiments of the present disclosure, the driving circuit DC of each first sub-pixel SP1 and the driving circuit DC of each second sub-pixel SP2 can be simplified. The driving circuit DC of the second sub-pixel SP2 in each pixel area PA can be insulated from the driving circuit DC of the first sub-pixel SP1 in the corresponding pixel area PA. Therefore, in the display apparatus according to one or more embodiments of the present disclosure, the light-emitting device 300 of the second sub-pixel SP2 in each pixel area PA can be controlled independently from the light-emitting device 300 of the first sub-pixel SP1 in the corresponding pixel area PA. As an example, the driving circuit DC of the second sub-pixel SP2 in each pixel area PA can be selectively connected to the light-emitting device 300 of the first sub-pixel SP1 in the corresponding pixel area PA, such that the light-emitting devices 300 of the first sub-pixel SP1 and the second sub-pixel SP2 may be both controlled by the driving circuit DC of the second sub-pixel SP2, vice versa. But the embodiments of the present disclosure are not limited thereto.

The driving circuit DC of each sub-pixel SP1 and SP2 can be supported by a device substrate 100. The device substrate 100 can include a rigid material or a flexible material. As an example, the device substrate 100 can include an insulating material. For example, the device substrate 100 can include glass or plastic. At least one insulating layers 110, 120, 130, 140 and 150 for reducing or preventing unintended electrical connection can be disposed on the device substrate 100. For example, a buffer insulating layer 110, a gate insulating layer 120, an interlayer insulating layer 130, a device planarization layer 140 and a bank insulating layer 150 can be disposed on the device substrate 100. However, embodiments of the present disclosure are not limited thereto. As an example, one or more of the above-mentioned layers may be omitted, or one or more additional layers may be further included.

The buffer insulating layer 110 can include an insulating material. The buffer insulating layer 110 can reduce or prevent pollution due to the device substrate 100 in a process of forming the driving circuit DC of each sub-pixel SP1 and SP2. For example, an upper surface of the device substrate 100 toward the driving circuit DC of each sub-pixel SP1 and SP2 can be covered by the buffer insulating layer 110. The first thin film transistor TR1, the second thin film transistor TR2 and the storage capacitor Cst of each sub-pixel SP1 and SP2 can be disposed over the buffer insulating layer 110.

The gate insulating layer 120 can be disposed on the buffer insulating layer 110. The gate insulating layer 120 can include an insulating material. The second gate electrode 223 of each sub-pixel SP1 and SP2 can be insulated from the second semiconductor pattern 221 of the corresponding sub-pixel SP1 and SP2 by the gate insulating layer 120. For example, the first semiconductor pattern and the second semiconductor pattern 221 of each sub-pixel SP1 and SP2 can be disposed between the buffer insulating layer 110 and the gate insulating layer 120, without being limited thereto.

The interlayer insulating layer 130 can be disposed on the gate insulating layer 120. The interlayer insulating layer 130 can include an insulating material. The second drain electrode 225 and the second source electrode 227 of each sub-pixel SP1 and SP2 can be insulated from the second gate electrode 223 of the corresponding sub-pixel SP1 and SP2 by the interlayer insulating layer 130. For example, the first gate electrode and the second gate electrode 223 of each sub-pixel SP1 and SP2 can be covered by the interlayer insulating layer 130 on the gate insulating layer 120. The first drain electrode, the first source electrode, the second drain electrode 225 and the second source electrode 227 of each sub-pixel SP1 and SP2 can be disposed on the interlayer insulating layer 130.

The device planarization layer 140 can be disposed on the interlayer insulating layer 130. For example, the first drain electrode, the first source electrode, the second drain electrode 225 and the second source electrode 227 of each sub-pixel SP1 and SP2 can be covered by the device planarization layer 140. The device planarization layer can include an insulating material. As an example, the device planarization layer 140 can include a material having a higher fluidity than the buffer insulating layer 110, the gate insulating layer 120 and the interlayer insulating layer 130, without being limited thereto. For example, the buffer insulating layer 110, the gate insulating layer 120 and the interlayer insulating layer 130 can be an inorganic insulating layer made of an inorganic insulating material, and the device planarization layer 140 can be an organic insulating layer made of an organic insulating material. A thickness difference due to the driving circuit DC of each sub-pixel SP1 and SP2 can be removed by the device planarization layer 140. For example, an upper surface of the device planarization layer 140 opposite to the device substrate 100 can be flat.

The bank insulating layer 150 can be disposed on the upper surface of the device planarization layer 140. The bank insulating layer 150 can include an insulating material. For example, the bank insulating layer 150 can be an organic insulating layer made of an organic insulating material, without being limited thereto. The bank insulating layer 150 of each sub-pixel SP1 and SP2 can expose a portion of the device planarization layer 140 in the corresponding sub-pixel SP1 and SP2. The light-emitting device 300 of each sub-pixel SP1 and SP2 can be disposed on a portion of the device planarization layer 140 exposed by the bank insulating layer 150. A portion of the device planarization layer 140 exposed by the bank insulating layer 150 can be defined as an emission area EA1 and EA2. For example, a first emission area EA1 can be defined in the first sub-pixel SP1 of each pixel area PA by the bank insulating layer 150, and a second emission area EA2 can be defined in the second sub-pixel SP2 of each pixel area PA by the bank insulating layer 150. A portion disposed between the emission areas EA1 and EA2 of each pixel area PA can be defined as a non-emission area. For example, the bank insulating layer 150 can be disposed within the non-emission area.

The second emission area EA2 of each pixel area PA can be disposed side by side with the first emission area EA1 of the corresponding pixel area PA in the first direction X. For example, the first emission area EA1 of each pixel area PA can be disposed close to the passenger seat PS, and the second emission area EA2 of each pixel area PA can be disposed close to the driver seat DS, without being limited thereto.

As an example, a plane of the first emission area EA1 and a plane of the second emission area EA2 can have a trapezoidal shape, without being limited thereto. For example, each of the first emission area EA1 and the second emission area EA2 can include a first side surface S1 extending in the second direction Y and a second side surface S2 parallel to the first side surface S1, and a length di of the second side surface S2 in the second direction Y can be longer than a length do of the first side surface S1 in the second direction Y. As an example, the second side surface S2 of the first emission area EA1 and the second side surface S2 of the second emission area EA2 may face opposite directions, without being limited thereto. Embodiments are not limited thereto. As an example, a plane of the first emission area EA1 and a plane of the second emission area EA2 can have various shapes other than the trapezoidal shape, such as a rectangular shape, an oval shape, a circular shape, etc. As an example, a plane of the first emission area EA1 and a plane of the second emission area EA2 can have the same shape or different shapes.

The second emission area EA2 of each pixel area PA can have a shape symmetric to the first emission area EA1 of the corresponding pixel area PA with respect to the second direction Y. For example, the second side surface S2 of the first emission area EA1 and the second side surface S2 of the second emission area EA2 in each pixel area PA can be disposed between the first side surface S1 of the first emission area EA1 and the first side surface S1 of the second emission area EA2 in the corresponding pixel area PA.

As an example, the second emission area EA2 of each pixel area PA can have a same size as the first emission area EA1 of the corresponding pixel area PA, without being limited thereto. The second emission area EA2 of each pixel area PA can have a same length as the first emission area EA1 of the corresponding pixel area PA in the first direction X. For example, the first side surface S1 of the second emission area EA2 in each pixel area PA can have a same length as the first side surface S1 of the first emission area EA1 in the corresponding pixel area PA, and the second side surface S2 of the second emission area EA2 in each pixel area PA can have a same length as the second side surface S2 of the first emission area EA1 in the corresponding pixel area PA.

The light-emitting device 300 of each sub-pixel SP1 and SP2 can overlap the emission area EA1 and EA2 of the corresponding sub-pixel SP1 and SP2. For example, the light-emitting device 300 of each first sub-pixel SP1 can be disposed on the device planarization layer 140 of the first emission area EA1 defined in the corresponding first sub-pixel SP1 by the bank insulating layer 150, and the light-emitting device 300 of each second sub-pixel SP2 can be disposed on the device planarization layer 140 of the second emission area EA2 defined in the corresponding second sub-pixel SP2 by the bank insulating layer 150.

The light-emitting device 300 of each sub-pixel SP1 and SP2 can emit light displaying a specific color. For example, the light-emitting device 300 of each sub-pixel SP1 and SP2 can include a first electrode 310, a light-emitting unit 320 and a second electrode 330, which are sequentially stacked on the device planarization layer 140.

The first electrode 310 and the second electrode 330 can include a conductive material. As an example, the second electrode 330 can include a different material from the first electrode 310, or can include the same material as the first electrode 310, without being limited thereto. For example, a transmittance of the second electrode 330 can be higher than a transmittance of the first electrode 310. For example, the first electrode 310 can have a higher reflectance than the second electrode 330. For example, the first electrode 310 can be a reflective electrode including a metal, such as aluminum (Al) and silver (Ag), and the second electrode 330 can be a transparent electrode made of a transparent conductive material, such as ITO and IZO, without being limited thereto.

The light-emitting unit 320 can generate light having luminance corresponding to a voltage difference between the first electrode 310 and the second electrode 330. For example, the light-emitting unit 320 can include at least one emission material layer (EML). As an example, the light-emitting unit 320 can have a multi-layer structure, without being limited thereto. For example, the light-emitting unit 320 can further include at least one of a hole injection layer (HIL), a hole transport layer (HTL), an electron transport layer (ETL) and an electron injection layer (EIL), without being limited thereto. The light generated by the light-emitting unit 320 can be emitted through the second electrode 330.

The first electrode 310 of each sub-pixel SP1 and SP2 can be electrically connected to the driving circuit DC of the corresponding sub-pixel SP1 and SP2. For example, the first electrode 310 of the first sub-pixel SP1 can be in direct contact with the second source electrode 227 of the corresponding first sub-pixel SP1 by penetrating the device planarization layer 140, and the first electrode 310 of the second sub-pixel SP2 can be in direct contact with the second source electrode 227 of the corresponding second sub-pixel SP2 by penetrating the device planarization layer 140. The first electrode 310 of the second sub-pixel SP2 in each pixel area PA can be insulated from the first electrode 310 of the first sub-pixel SP1 in the corresponding pixel area PA, for example, by the bank insulating layer 150. For example, the bank insulating layer 150 can cover an edge of the first electrode 310 in each sub-pixel SP1 and SP2. As an example, a connection point between the second source electrode 227 and the first electrode 310 in each sub-pixel SP1 and SP2 can be covered by the bank insulating layer 150, or may overlap the corresponding emission area, without being limited thereto.

An encapsulation structure 400 can be disposed on the light-emitting device 300 of each sub-pixel SP1 or SP2. The damage of the light-emitting devices 300 due to external impact and moisture can be reduced or prevented by the encapsulation structure 400. The encapsulation structure 400 can extend beyond the first emission area EA1 and the second emission area EA2 defined in each pixel area PA. For example, the encapsulation structure 400 can include a region overlapping with the first emission area EA1 of each pixel area PA, a region overlapping with the second emission area EA2 of each pixel area PA, and a region overlapping with the non-emission area. As an example, the encapsulation structure 400 can have a multi-layer structure or a single layer structure. For example, the encapsulation structure 400 can include a first encapsulating layer 410, a second encapsulating layer 420 and a third encapsulating layer 430, which are sequentially stacked. As an example, the second encapsulating layer 420 can include a material having a higher fluidity than the first encapsulating layer 410 and the third encapsulating layer 430, without being limited thereto. For example, the first encapsulating layer 410 and the third encapsulating layer 430 can be an inorganic encapsulating layer made of an inorganic insulating material, and the second encapsulating layer 420 can be an organic encapsulating layer made of an organic insulating material, without being limited thereto. A thickness difference due to the light-emitting device 300 of each sub-pixel SP1 and SP2 can be removed by the second encapsulating layer 420.

As an example, a barrier structure 500 can be disposed on an upper surface of the encapsulation structure 400 opposite to the device substrate 100. The barrier structure 500 can have a multi-layer structure. For example, the barrier structure 500 can include a lower barrier pattern 510 and an upper barrier pattern 520 disposed over the lower barrier pattern 510. As an example, the upper barrier pattern 520 can be spaced apart from the lower barrier pattern 510. As an example, the upper barrier pattern 520 can be spaced apart from the lower barrier pattern 510 in the third direction Z, without being limited thereto. For example, the upper barrier pattern 520 can be disposed on an optical insulating layer 600 covering the lower barrier pattern 510. The optical insulating layer 600 can include a transparent material. For example, the optical insulating layer 600 can include an organic insulating material, without being limited thereto. The optical insulating layer 600 can extend along the encapsulation structure 400. For example, the optical insulating layer 600 can include a region overlapping with the first emission area EA1 of each pixel area PA, a region overlapping with the second emission area EA2 of each pixel area PA, and a region overlapping with the non-emission area.

The lower barrier pattern 510 and the upper barrier pattern 520 can include a material capable to blocking light. For example, the lower barrier pattern 510 and the upper barrier pattern 520 can include a black dye, such as carbon black and iron Black, without being limited thereto. As an example, the upper barrier pattern 520 can include a same material as the lower barrier pattern 510, or include a different material from the lower barrier pattern 510.

The lower barrier pattern 510 can include lower openings 510h overlapping with the pixel areas PA. For example, the lower openings 510h can be filled by the optical insulating layer 600. The upper barrier pattern 520 can include upper openings 520h overlapping with the lower openings 510h. For example, each of the pixel areas PA can overlap one of the lower openings 510h and one of the upper openings 520h. Thus, in the display apparatus according to one or more embodiments of the present disclosure, the second emission area EA2 of each pixel area PA can emit light through the same lower opening 510h and the same upper opening 520h as the first emission area EA1 of the corresponding pixel area PA.

As an example, the upper opening 520h of each pixel area PA can have a planar shape corresponding to the lower opening 510h of the corresponding pixel area PA. For example, the lower opening 510h and the upper opening 520h of each pixel area PA can have a planar shape of a bar extending in the second direction Y, without being limited thereto. The center of the upper opening 520h on each pixel area PA can coincide with the center of the lower opening 510h on the corresponding pixel area PA in a plan view. For example, each of the upper openings 520h can have a smaller size than each lower opening 510h, without being limited thereto. For example, a width of each upper opening 520h in the first direction X can be smaller than a width of each lower opening 510h in the first direction X. For example, a width of each upper opening 520h in the second direction Y can be smaller than, equal to or greater than a width of each lower opening 510h in the second direction Y. As an example, the entirety of the upper opening 520h of each pixel area PA can overlap the lower opening 510h of the corresponding pixel area PA, without being limited thereto. As an example, the upper opening 520h of each pixel area PA can be disposed within the lower opening 510h of the corresponding pixel area PA, without being limited thereto. As an example, the upper opening 520h of each pixel area PA can be disposed in a center portion of the lower opening 510h of the corresponding pixel area PA in the first direction X, or may be biased from the center portion of the lower opening 510h of the corresponding pixel area PA in the first direction X, without being limited thereto.

The lower opening 510h and the upper opening 520h of each pixel area PA can include a region disposed between the first emission area EA1 and the second emission area EA2 of the corresponding pixel area PA. The upper opening 520h of each pixel area PA can overlap partially with the first emission area EA1 and the second emission area EA2 of the corresponding pixel area PA. For example, each of the first emission area EA1 and the second emission area EA2 in each pixel area PA can include a first region E1 overlapping with the upper barrier pattern 520 and a second region E2 overlapping with the upper opening 520h of the corresponding pixel area PA.

The second region E2 of the first emission area EA1 and the second region E2 of the second emission area EA2 in each pixel area PA can be disposed between the first region E1 of the first emission area EA1 and the second region E2 of the second emission area EA2 in the corresponding pixel area PA. For example, the first region E1 of each emission area EA1 and EA2 can include the first side surface S1, and the second region E2 of each emission area EA1 and EA2 can include the second side surface S2. Thus, in the display apparatus according to one or more embodiments of the present disclosure, as an example, the second region E2 of each emission area EA1 and EA2 can have a larger size than the first region E1 of the corresponding emission area EA1 and EA2, without being limited thereto. For example, the first side surfaces S1 of each pixel area PA can overlap the upper barrier pattern 520. As an example, the second region E2 of each emission area EA1 and EA2 can have a longer length in the second direction Y than the first region E1 of the corresponding emission area EA1 and EA2, without being limited thereto.

Light emitted from the first emission area EA1 of each pixel area PA can travel toward the driver seat DS by passing through the lower opening 510h and the upper opening 520h of the corresponding pixel area PA, and light emitted from the second emission area EA2 of each pixel area PA can travel toward the passenger seat PS by passing through the lower opening 510h and the upper opening 520h of the corresponding pixel area PA. As an example, in the display apparatus according to one or more embodiments of the present disclosure, the light emitted from the first emission area EA1 of each pixel area PA through the lower opening 510h and the upper opening 520h of the corresponding pixel area PA can be the first light L1 recognized by the driver of the driver seat DS, and the light emitted from the second emission area EA1 of each pixel area PA through the lower opening 510h and the upper opening 520h of the corresponding pixel area PA can be the second light L2 recognized by the passenger of the passenger seat PS. The light emitted from the first emission area EA1 of each pixel area PA toward the passenger seat PS and the light emitted from the second emission area EA2 of each pixel area PA toward the driver seat DS can be blocked by the lower barrier pattern 510 or the upper barrier pattern 520. Thus, in the display apparatus according to one or more embodiments of the present disclosure, the second light L2 emitted from the second emission area EA2 of each pixel area PA through the lower opening 510h and the upper opening 520h of the corresponding pixel area PA will not be recognized by the driver of the driver seat DS, and the first light L1 emitted from the first emission area EA1 of each pixel area PA through the lower opening 510h and the upper opening 520h of the corresponding pixel area PA will not be recognized by the passenger of the passenger seat PS. Therefore, in the display apparatus according to one or more embodiments of the present disclosure, gaze dispersion of the driver due to the second image realized by the second light L2 can be reduced or prevented.

Pixel lenses 700 can be disposed on the upper barrier pattern 520. The pixel lenses 700 can overlap the pixel areas PA. The pixel lens 700 of each pixel area PA can include a lens central point 700c disposed between the first emission area EA1 and the second emission area EA2 of the corresponding pixel area PA in the first direction X. For example, each of the pixel lenses 700 can overlap one of the upper openings 520h. The pixel lens 700 on each pixel area PA can function as a convex lens. For example, a surface of each pixel lens 700 opposite to the device substrate 100 can have a convex shape. The first light L1 and the second light L2 passing through the upper opening 520h of each pixel area PA can be focused by the pixel lens 700 on the corresponding pixel area PA.

The pixel lens 700 of each pixel area PA can have a planar shape corresponding to the upper opening 520h of the corresponding pixel area PA. For example, the pixel lens 700 of each pixel area PA can have a planar shape of a bar extending in the second direction Y. The pixel lens 700 of each pixel area PA can have a larger size than the upper opening 520h of the corresponding pixel area PA. For example, the upper opening 520h of each pixel area PA can be filled by the pixel lens 700 of the corresponding pixel area PA. An edge of the pixel lens 700 on each pixel area PA can overlap the upper barrier pattern 520. Thus, in the display apparatus according to one or more embodiments of the present disclosure, the light extraction of the first light L1 and the second light L2 of each pixel area PA can be improved. As an example, the pixel lens 700 of each pixel area PA can have a smaller size than the lower openings 510h of the corresponding pixel area PA, without being limited thereto.

The center of the upper opening 520h on each pixel area PA can coincide with the lens central point 700c of the pixel lens 700 on the corresponding pixel area PA, in a plan view. For example, the lower opening 510h and the upper opening 520h of each pixel area PA can have a symmetric shape with respect to the lens central point 700c of the corresponding pixel area PA, in a plan view. A virtual center line VC passing through the lens central point 700c of each pixel area PA in the second direction Y can be disposed between the first emission area EA1 and the second emission area EA2 of the corresponding pixel area PA. Thus, in the display apparatus according to one or more embodiments of the present disclosure, the deviation in the quality between the first image and the second image due to the pixel lens 700 of each pixel area PA can be reduced or prevented.

A lens planarization layer 800 can be disposed on the pixel lens 700 of each pixel area PA. The lens planarization layer 800 can reduce or prevent the damage of the pixel lenses 700 due to the external impact. For example, the pixel lens 700 of each pixel area PA can be completely covered by the lens planarization layer 800. The lens planarization layer 800 can extend onto an upper surface of the upper barrier pattern 520 opposite to the device substrate 100. For example, the lens planarization layer 800 can include a region overlapping with the pixel lenses 700 and a region overlapping with the upper barrier pattern 520.

The lens planarization layer 800 can include an insulating material. For example, the lens planarization layer 800 can be an organic insulating material, without being limited thereto. A thickness difference due to the pixel lenses 700 can be removed by the lens planarization layer 800. For example, an upper surface of the lens planarization layer 800 opposite to the device substrate 100 can be flat. As an example, the lens planarization layer 800 can have a refractive index smaller than the pixel lens 700 of each pixel area PA. For example, in the display apparatus according to one or more embodiments of the present disclosure, the light passing through the pixel lens 700 of each pixel area PA can be focused by a difference in refractive index between the pixel lens 700 of the corresponding pixel area PA and the lens planarization layer 800.

FIG. 6 is graphs showing luminance according to a viewing angle in a comparison display apparatus ① in which opposite side surfaces of each emission area have a same length and in the display apparatus ② according to one or more embodiments of the present disclosure.

Referring to FIG. 6, in the comparison display apparatus ① and the display apparatus ② according to one or more embodiments of the present disclosure, the first light L1 of each pixel area PA can't be recognized at a viewing angle of 10° to 90°, and the second light L2 of each pixel area PA can't be recognized at a viewing angle of -90° to -10°. Thus, in the comparison display apparatus ① and the display apparatus ② according to one or more embodiments of the present disclosure, gaze dispersion of the driver due to the second image can be reduced or prevented, when the first image by the first light L1 of each pixel area PA can be provided to the driver of the driver seat DS, and the second image by the second light L2 of each pixel area PA can be provided to the passenger sitting in the passenger seat PS.

Referring to FIG. 6, in the display apparatus ② according to one or more embodiments of the present disclosure, the first light L1 of each pixel area PA can have the relative high luminance at a viewing angle of -40° to 10°, and the second light L2 of each pixel area PA can have the relative high luminance at a viewing angle of -10° to 40°. As an example, in the display apparatus ② according to one or more embodiments of the present disclosure, the luminance of the light L1 and L2 travelling between the driver seat DS and the passenger seat PS can be increased by a difference in the length between the first side surface S1 and the second side surface S2 of each emission area EA1 and EA2. Thus, in the display apparatus ② according to one or more embodiments of the present disclosure, a deviation in the luminance between a portion Ic of the image displayed between the driver seat DS and the passenger seat PS and portions Id and Ip of the image displayed on the driver seat DS and the passenger seat PS can be reduced or minimized. Therefore, in the display apparatus ② according to one or more embodiments of the present disclosure, the quality of the image shared between the driver of the driver seat DS and the passenger of the passenger seat PS can be improved.

Accordingly, the display apparatus according to one or more embodiments of the present disclosure can include the device substrate 100 including the pixel areas PA, the bank insulating layer 150 defining the first emission area EA1 and the second emission area EA2, which are disposed side by side within each pixel area PA in the first direction X, the lower barrier pattern 510 including the lower openings 510h overlapping with the pixel areas PA, the upper barrier pattern 520 including the upper openings 520h overlapping with the lower openings 510h, and the pixel lenses 700 overlapping with the upper openings 520h, wherein the virtual center line VC passing through the lens central point 700c of the pixel lens 700 of each pixel area PA in the second direction Y can be disposed between the first emission area EA1 and the second emission area EA2 of the corresponding pixel area PA in the first direction X, wherein each of the first emission area EA1 and the second emission area EA2 in each pixel area PA can include the first side surface S1 extending in the second direction Y and the second side surface S2 disposed between the virtual center line VC and the first side surface S1, and wherein the length di of the second side surface S2 in the second direction Y can be longer than the length do of the first side surface S1 in the second direction Y. Thus, in the display apparatus according to one or more embodiments of the present disclosure, gaze dispersion of the driver can be reduced or prevented when different images are provided to the driver of the driver seat DS and the passenger of the passenger seat PS, and the difference in the luminance between a portion Ic of the image displayed between the driver seat DS and the passenger seat PS and potions Id and Ip of the image displayed on the driver seat DS and the passenger seat PS can be reduced or minimized when the driver of the driver seat DS and the passenger of the passenger seat PS share an single image. Therefore, in the display apparatus according to one or more embodiments of the present disclosure, as an example, gaze dispersion of the driver due to the second image can be reduced or prevented while the car is in a moving state, and the quality of the image shared between the driver of the driver seat DS and the passenger of the passenger seat PS can be improved when the car is stopped.

And, in the display apparatus according to one or more embodiments of the present disclosure, as an example, the first light L1 emitted from the first emission area EA1 of each pixel area PA through the lower opening 510h and the upper opening 520h of the corresponding pixel area PA can have the maximum or increased luminance in a direction toward the driver seat DS, and the second light L2 emitted from the second emission area EA2 of each pixel area PA through the lower opening 510h and the upper opening 520h of the corresponding pixel area PA can have the maximum or increased luminance in a direction toward the passenger seat PS. As an example, in the display apparatus according to one or more embodiments of the present disclosure, luminance of the first image by the first light L1 and luminance of the second image by the second light L2 can be increased or maximized. Thus, in the display apparatus according to one or more embodiments of the present disclosure, the low-power operation can be possible, and the power consumption can be reduced.

In the display apparatus according to one or more embodiments of the present disclosure, the display panel DP can include a display area AA in which the pixel areas PA are disposed, and a bezel area BZ disposed outside the display area AA, as shown in FIG. 2. The bezel area BZ can extend along an edge of the display area AA. For example, the display area AA can be fully or partially surrounded by the bezel area BZ. As an example, a gate driver GD electrically connected to the gate line GL, a data driver electrically connected to the data line DL, and a power unit electrically connected to the power voltage supply line PL can be disposed outside the display area AA. As an example, at least one of the gate driver GD, the data driver and the power unit can be disposed on the bezel area BZ, or may not be disposed on the bezel area BZ. For example, the display apparatus according to one or more embodiments of the present disclosure can be a GIP (Gate In Panel) type display apparatus in which the gate driver GD is formed on the bezel area BZ. However, embodiments of the present disclosure are not limited thereto. As an example, the gate driver GD, the data driver or the power unit may be connected to the display panel DP using a tape automated bonding (TAB) method, a chip-on-glass (COG) method, a chip-on-panel (COP) method, or a chip-on-film (COF) method, without being limited thereto.

In the display apparatus according to one or more embodiments of the present disclosure, as an example, the arrangement of the pixel areas PA in the first direction X and the second direction Y has a staggered shape. The red pixel areas R-PA, the green pixel area G-PA and the blue pixel areas B-PA of the pixel areas PA can be repeated in the first direction X or the second direction Y. For example, in the display apparatus according to one or more embodiments of the present disclosure, the red pixel areas R-PA can be disposed side by side in the second direction Y, each of the blue pixel areas B-PA can be disposed side by side with one of the red pixel areas R-PA in the first direction X, and each of the green pixel areas G-PA can be disposed side by side with one of the red pixel areas R-PA in a direction inclined to the first direction X and the second direction Y, as shown in FIG. 3. Embodiments are not limited thereto. As an example, the arrangement of the pixel areas PA may be modified in various ways.

As an example, a distance between the pixel areas PA adjacent in the second direction Y can be a same as a distance between the pixel areas PA adjacent in the first direction X, without being limited thereto. The pixel lenses 700 overlapping with the pixel areas PA can have a constant interval in the first direction X and the second direction Y. Similarly, the upper openings overlapping with the pixel areas PA can also have a constant interval in the first direction X and the second direction Y, without being limited thereto. For example, a distance dy between the pixel lenses 700 adjacent in the second direction Y can be the same as a distance dx between the pixel lenses 700 adjacent in the first direction X, without being limited thereto. As an example, a distance dd between the pixel lenses 700 adjacent in a direction inclined to the first direction X and the second direction Y can be smaller than the distance dy between the pixel lenses 700 adjacent in the second direction Y, without being limited thereto. Thus, in the display apparatus according to one or more embodiments of the present disclosure, the distance between the pixel areas PA in the first direction X and the second direction Y can be increased by the arrangement of the pixel areas PA having a zigzag shape, and the interference between the first light L1 of each pixel area PA and the second light L2 of the pixel area PA adjacent to the corresponding pixel area PA in the first direction X can be reduced. Therefore, in the display apparatus according to one or more embodiments of the present disclosure, the visibility of the first image provided to the driver of the driver seat DS and the visibility of the second image provided to the passenger of the passenger seat PS can be improved while the car is in moving state.

Further, in the display apparatus according to one or more embodiments of the present disclosure, a size of the first emission area EA1 defined in each pixel area PA and a size of the second emission area EA2 defined in each pixel area PA can be increased by reducing the interference between the first light L1 and the second light L2. Thus, in the display apparatus according to one or more embodiments of the present disclosure, the amount of the first light L1 traveling toward the driver seat DS and the amount of the second light L2 traveling toward the passenger seat PS can be increased. Therefore, in the display apparatus according to one or more embodiments of the present disclosure, the power consumption can be effectively reduced.

The display apparatus according to one or more embodiments of the present disclosure is described that the driving circuit DC consists of the first thin film transistor TR1, the second thin film transistor TR2 and the storage capacitor Cst. However, in the display apparatus according to one or more other embodiments of the present disclosure, the driving circuit DC can include a driving thin film transistor and at least one switching thin film transistors. For example, in the display apparatus according to one or more other embodiments of the present disclosure, the driving circuit DC can further include a third thin film transistor to initialize the storage capacitor Cst according to the gate signal. The third thin film transistor may include a third semiconductor pattern, a third gate electrode, a third drain electrode and a third source electrode. For example, the third gate electrode can be electrically connected to the gate line GL, the third drain electrode can be electrically connected to an initial line applying a signal for the initialization of the storage capacitor Cst, and the third source electrode can be electrically connected to the storage capacitor Cst. Thus, in the display apparatus according to one or more other embodiments of the present disclosure, the degree of freedom in the configuration of the driving circuit DC can be improved.

In the display apparatus according to one or more embodiments of the present disclosure, the location and the electric connection of the first drain electrode, the first source electrode, the second drain electrodes 225 and the second source electrode 227 in each driving circuit DC can vary depending on the configuration of the corresponding driving circuit DC and/or the type of the corresponding thin film transistors TR1 and TR2. For example, in the display apparatus according to one or more other embodiments of the present disclosure, the second gate electrode 223 can be electrically connected to the first drain electrode. Thus, in the display apparatus according to one or more other embodiments of the present disclosure, the degree of freedom in the configuration of each driving circuit DC and the type of each thin film transistor TR1 and TR2 can be improved.

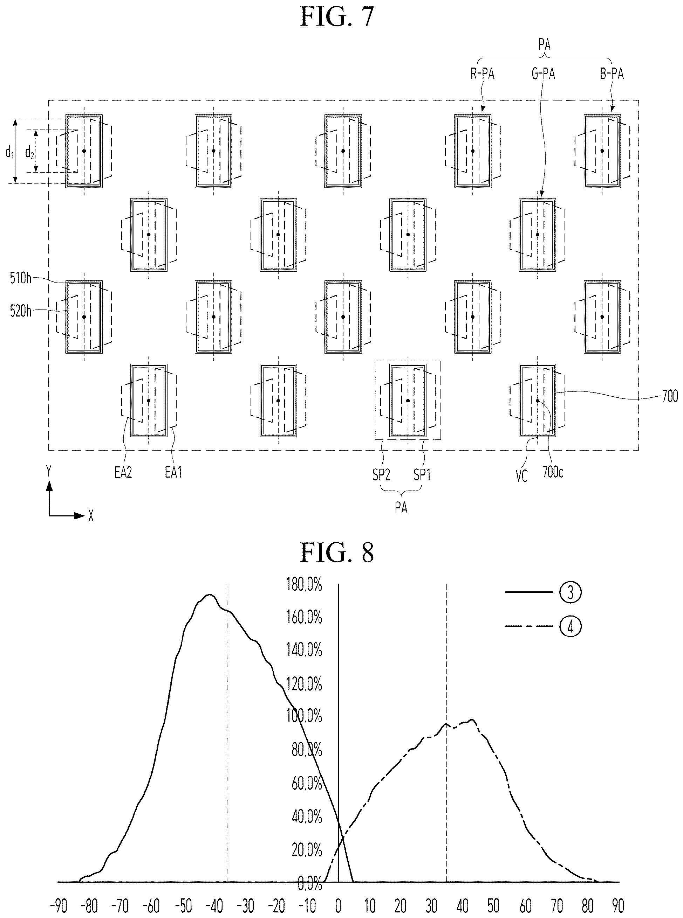

The display apparatus according to one or more embodiments of the present disclosure is described that the second emission area EA2 of each pixel area PA has a same size as the first emission area EA1 of the corresponding pixel area PA. However, in the display apparatus according to one or more other embodiments of the present disclosure, the first emission area EA1 and the second emission area EA2 of each pixel area PA can have different sizes. For example, in the display apparatus according to one or more other embodiments of the present disclosure, the second emission area EA2 of each pixel area PA can have a smaller size than the first emission area EA1 of the corresponding pixel area PA, as shown in FIG. 7. A length d2 of the second side surface of the second emission area EA2 disposed close to the first emission area EA1 in each pixel area PA can be smaller than a distance d1 of the second side surface of the first emission area EA1 disposed close to the second emission area EA2 in the corresponding pixel area PA. Embodiments are not limited thereto. As an example, the second emission area EA2 of each pixel area PA can have a greater size than the first emission area EA1 of the corresponding pixel area PA, without being limited thereto.

Each of the first emission area EA1 and the second emission area EA2 in each pixel area PA can include the first region overlapping with the upper barrier pattern and the second region overlapping with the upper opening 520h of the corresponding pixel area PA. As an example, the first region of the second emission area EA2 in each pixel area PA can have a smaller size than the first region of the first emission area EA1 in the corresponding pixel area PA, and the second region of the second emission area EA2 in each pixel area PA can have a smaller size than the second region of the first emission area EA1 in the corresponding pixel area PA, without being limited thereto. Thus, in the display apparatus according to one or more other embodiments of the present disclosure, the amount of the first light travelling toward the driver seat from each pixel area PA through one of the lower openings 510h and one of the upper openings 520h can be larger than the amount of the second light travelling toward the passenger seat from each pixel area PA through one of the lower openings 510h and one of the upper openings 520h.

FIG. 8 is a view showing a luminance graph of the first light ③ emitted from each pixel area PA according to a viewing angle and a luminance graph of the second light ④ emitted from each pixel area PA according to a viewing angle in the display apparatus according to one or more other embodiments of the present disclosure.

Referring to FIG. 8, in the display apparatus according to one or more other embodiments of the present disclosure, the first light ③ of each pixel area PA can't be recognized at a viewing angle of 10° to 90°, the second light ④ of each pixel area PA can't be recognized at a viewing angle of -90° to -10°, and the first light ③ of each pixel area PA can have the maximum luminance larger than the second light ④ of each pixel area PA. Thus, in the display apparatus according to one or more other embodiments of the present disclosure, the deterioration in the quality of the first image provided to the driver of the driver seat DS by the first light ③ displayed for a longer time than the second image provided to the passenger of the passenger seat PS by the second light ④ according to time can be reduced. As an example, in the display apparatus according to one or more other embodiments of the present disclosure, the difference in the quality between the first image and the second image according to time can be reduced. Therefore, in the display apparatus according to one or more other embodiments of the present disclosure, the lifespan of the display panel can be effectively increased.

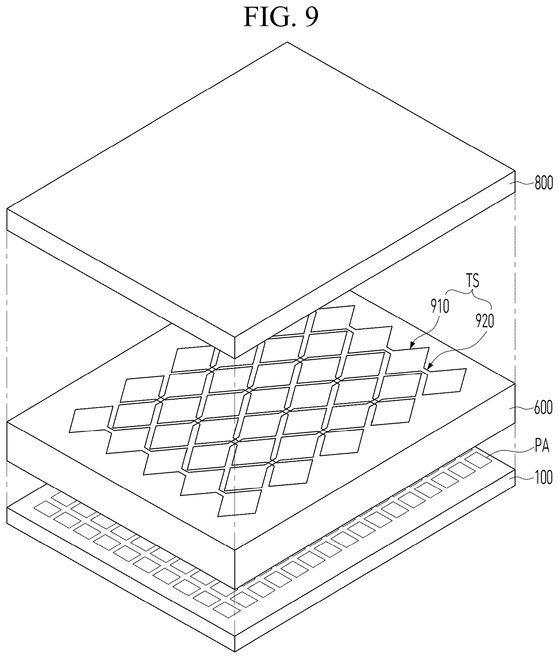

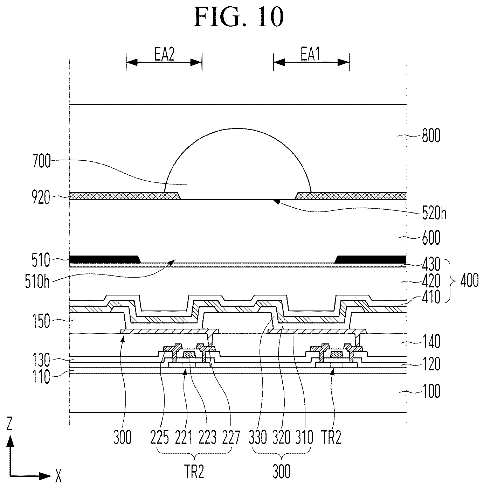

The display apparatus according to one or more embodiments of the present disclosure is described that the upper barrier pattern 520 includes a same material as the lower barrier pattern 510. However, in the display apparatus according to one or more other embodiments of the present disclosure, the upper barrier pattern 520 can include a different material from the lower barrier pattern 510. For example, in the display apparatus according to one or more other embodiments of the present disclosure, a touch sensor TS for sensing a touch of the user or a tool can be disposed between the optical insulating layer 600 and the lens planarization layer 800, as shown in FIGS. 9 and 10.

The touch sensor TS can include touch electrodes 910 and bridge electrodes 920 connecting between the touch electrodes 910. The touch electrodes 910 and the bridge electrode 920 can include a conductive material. The touch electrodes 910 and the bridge electrode 920 can include a material capable of blocking light. For example, the touch electrodes 910 and the bridge electrodes 920 can include a metal. As an example, at least some of the bridge electrodes 920 can include a different material from the touch electrodes 910, without being limited thereto. For example, at least some of the bridge electrode 920 can be disposed on a different layer from the touch electrodes 910.

As an example, a lower surface of each touch electrode 910 toward the device substrate 100 can be in direct contact with the upper surface of the optical insulating layer 600. For example, the touch electrodes 910 can be disposed between the optical insulating layer 600 and the lens planarization layer 800. The touch electrodes 910 can be disposed outside the first emission area EA1 and the second emission area EA2 defined in each pixel area PA. For example, the touch electrodes 910 can be disposed in the non-emission area. An edge of each pixel lens 700 can overlap one of the touch electrodes 910. The touch electrodes 910 can overlap the lower barrier pattern 510. The travelling direction of the light passing through each lower opening 510h can be limited by the touch electrodes 910. For example, in the display apparatus according to one or more other embodiments of the present disclosure, the touch electrodes 910 can function as the upper barrier pattern. A space between the touch electrodes 910 can function as the upper opening 520h. As an example, in the display apparatus according to one or more other embodiments of the present disclosure, a process of forming the upper barrier pattern can be omitted. Therefore, in the display apparatus according to one or more other embodiments of the present disclosure, the process efficiency can be improved.

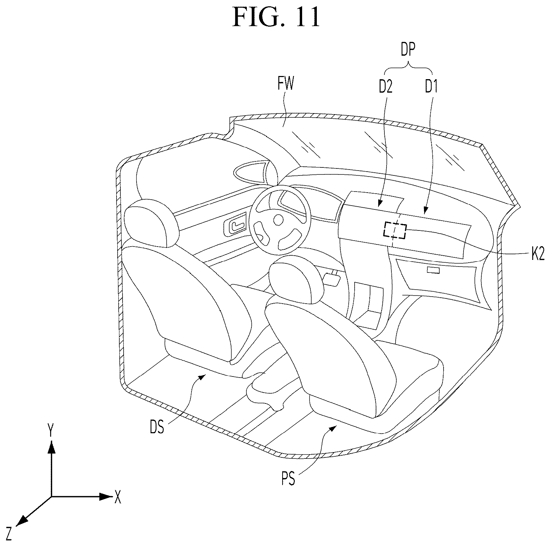

The display apparatus according to one or more embodiments of the present disclosure is described that the display pane DP is disposed between the driver seat DS and the passenger seat PS. However, in the display apparatus according to one or more other embodiments of the present disclosure, the display panel DP can include a region in front of the driver seat DS and/or the passenger seat PS. For example, in the display apparatus according to one or more other embodiments of the present disclosure, the display panel DP can includes a first panel region D1 disposed in front of the passenger seat PS, and a second panel region D2 disposed between the driver seat DS and the passenger seat PS, as shown in FIG. 11. The first panel region D1 and the second panel region D2 can extend in the first direction X. The second panel region D2 can be in direct contact with the first panel region D1. For example, in the display apparatus according to one or more other embodiments of the present disclosure, an integrated display panel DP in which the first panel region D1 and the second panel region D2 share the device substrate 100 can be used. Thus, in the display apparatus according to one or more other embodiments of the present disclosure, the degree of freedom in the location and the shape of the display panel DP can be improved.

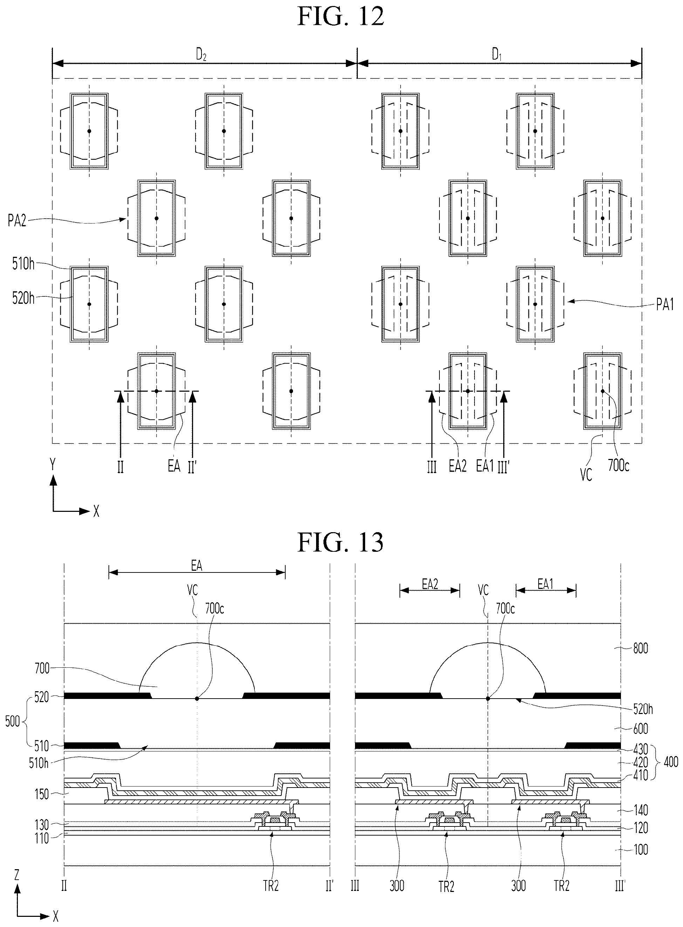

In the display apparatus according to one or more other embodiments of the present disclosure, first pixel areas PA1 can be disposed within the first panel region D1, and second pixel areas PA2 can be disposed within the second panel region D2. An emission area defined in each second pixel area PA2 can have a different shape from the emission area defined in each first pixel area PA1. For example, in the display apparatus according to one or more other embodiments of the prevent disclosure, the first emission area EA1 and the second emission area EA2 which are disposed side by side in the first direction X can be defined in each first pixel area PA1, and a single emission area EA can be defined in each second pixel area PA2, as shown in FIGS. 12 and 13.

A planar shape of the emission area EA defined in each second pixel area PA2 can be the same as the combination of the planar shape of the first emission area EA1 and the planar shape of the second emission area EA2, which are defined in each first pixel area PA1. For example, a single light-emitting device 300 can be disposed in each second pixel area PA2. As an example, the emission area EA of each second pixel area PA2 can overlap the lower openings 510h of the lower barrier pattern 510 and the upper openings 520h of the upper barrier pattern 520, without being limited thereto. As an example, the pixel lens 700 of each second pixel area PA2 can overlap the emission area EA of the corresponding second pixel area PA2. For example, the lens central point 700c of the pixel lens 700 on each second pixel area PA2 can be disposed within the emission area EA of the corresponding second pixel area PA2, without being limited thereto. However, embodiments of the present disclosure are not limited thereto. As an example, at least one of the lower barrier pattern 510, the upper barrier pattern 520 and the pixel lens 700 may be omitted from each second pixel area PA2. Thus, in the display apparatus according to one or more other embodiments of the present disclosure, an image generated by the second emission area EA2 of the first panel area D1 can't be optionally recognized by the driver of the driver seat DS, and an image generated by the second panel region D2 can be shared between the driver of the driver seat DS and the passenger of the passenger seat PS. For example, in the display apparatus according to one or more other embodiments of the present disclosure, the first image containing information related to the operation of the car be optionally provided to the driver of the driver seat DS using the second panel region D2, the second image containing information unrelated to the operation of the car can be optionally provided to the passenger of the passenger seat PS using the second emission area EA2 of the first panel region D1, and a third image shared between the driver of the driver seat DS and the passenger of the passenger seat PS can be optionally provided using the first panel region D1 and the second panel region D2. The second image can be provided simultaneously with the first image. As an example, the third image can't be provided simultaneously with the first image and the second image, without being limited thereto. For example, the second image can be provided simultaneously with the first image to the driver of the driver seat DS and the passenger of the passenger seat PS, or the third image can be provided to the driver of the driver seat DS and the passenger of the passenger seat PS. As an example, in the display apparatus according to one or more other embodiments of the present disclosure, the difference in sense at a boundary between a portion of the third image realized by the first panel region D1 and a portion of the third image realized by the second panel region D2 due to the difference in the shape between the planar shape of the emission area EA defined in each second pixel area PA2 and the combination of the planar shape of the first emission area EA1 and the planar shape of the second emission area EA2 defined in each first pixel area PA1 can be reduced. Therefore, in the display apparatus according to one or more other embodiments of the present disclosure, the degree of freedom in the configuration of the display panel DP can be improved.

In the display apparatus according to one or more other embodiments of the present disclosure, the display panels DP can include a plurality of panel part disposed side by side in the first direction X and the second direction Y. For example, in the display apparatus according to one or more other embodiments of the present disclosure, the display panel DP can include a first panel part, a second panel part disposed side by side with the first panel part in the first direction X, a third panel part disposed side by side with second panel part in the second direction Y, and a fourth panel part disposed side by side with the second panel part in the first direction X. The second panel part can be disposed between the first panel part and the fourth panel part in the first direction X. For example, the display apparatus according to one or more other embodiments of the present disclosure can include the display panel DP disposed in the car, wherein the first panel part can be disposed in front of the passenger seat PS, the second panel part and the third panel part can be disposed between the driver seat DS and the passenger seat PS, and the fourth panel part can be disposed in front of the driver seat DS. The first panel part, the second panel part and the fourth panel part can be spaced from each other. The third panel part can be in direct contact with the second panel part. As an example, the first panel part, the second panel part, the third panel part and the fourth panel part can have a same configuration, without being limited thereto. The first panel part, the second panel part, the third panel part and the fourth panel part can display different images. Thus, in the display apparatus according to one or more other embodiments of the present disclosure, the different images can be effectively provided to viewers located in various directions.

In the result, the display apparatus according to one or more embodiments of the present disclosure can comprise the device substrate including the pixel areas, the upper barrier pattern on the device substrate and the pixel lenses on the upper barrier pattern, wherein each of the pixel areas can include the first emission area and the second emission area which are disposed side by side in the first direction, the lens central point of each pixel lens can be disposed between the first emission area and the second emission area of one of the pixel areas, the upper barrier pattern can include the upper openings overlapping with pixel lenses, the first emission area and the second emission area of each pixel area can be partially exposed by one of the upper openings, a length of each emission area in the second direction perpendicular to the first direction can be reduced as it moves away from the corresponding lens central point. Thus, in the display apparatus according to one or more embodiments of the present disclosure, the luminance of the light travelling toward between users sharing the image can be increased. Thereby, in the display apparatus according to one or more embodiments of the present disclosure, the image shared between the users can be improved. And, in the display apparatus according to one or more embodiments of the present disclosure, the low-power operation can be possible, and the power consumption can be reduced.

Although it is described that the display pane DP is disposed between the driver seat DS and the passenger seat PS, embodiments are not limited thereto. As an example, the display pane DP may be disposed at any location in a vehicle. As an example, the display pane DP may be disposed in an electrical device other than the vehicle, such as a TV, a computer, a laptop, a portable device, a household appliance, a building, etc.
The present disclosure also includes a number of example according to the following numbered clauses.
1. A display panel, comprising:
   a device substrate including a plurality of first pixel areas;
   an upper barrier pattern disposed over the device substrate, the upper barrier pattern comprising a plurality of upper openings,
   wherein each of the plurality of first pixel areas includes a first emission area and a second emission area arranged in a first direction,
   wherein each of the first emission area and the second emission area included in a first pixel area of the plurality of first pixel areas partially overlaps an upper opening of the plurality of upper openings,
   wherein each of the first emission area and the second emission area includes a first side and a second side extending in a second direction perpendicular to the first direction, the second side being longer than the first side,
   wherein the second side of the first emission area and the second side of the second emission area overlap the upper opening, and
   wherein the first side of the first emission area and the first side of the second emission area overlap the upper barrier pattern.
2. The display panel according to clause 1, wherein the device substrate further comprises a plurality of second pixel areas, and wherein each of the plurality of second pixel areas includes one emission area.
3. The display panel according to clause 1 or clause 2, wherein the upper opening has a planar shape of a bar extending in the second direction.
4. The display panel according to any preceding clause, wherein each of the first emission area and the second emission area has a planar shape of a trapezoidal shape.
5. The display panel according to any preceding clause, wherein each of the plurality of first pixel areas is configured to display a specific color, and
   wherein the first emission area and the second emission area included in the first pixel area are configured to realize a same color.
6. The display panel according to any preceding clause, wherein a light-emitting device of the first emission area and a light-emitting device of the second emission area are connected to separate driving circuits.
7. The display panel according to any preceding clause, wherein each of the plurality of first pixel areas further includes a non-emission area between the first emission area and the second emission area and overlaps with the upper opening, and
   wherein each of the plurality of first pixel areas further includes a bank insulating layer disposed within the non-emission area.
8. The display panel according to any preceding clause, wherein each of the plurality of first pixel areas further includes a pixel lens disposed on the upper barrier pattern and overlaps the upper opening, and
   wherein a lens central point of the pixel lens is disposed between the first emission area and the second emission area.
9. The display panel according to clause 8, wherein the first emission area and the second emission area included in the first pixel area are configured to emit light through the upper opening and the pixel lens.
10. The display panel according to any preceding clause, further comprising:
   a lower barrier pattern disposed between the device substrate and the upper barrier pattern, the lower barrier pattern including a lower opening,
   wherein the lower opening overlaps the upper opening, and
   wherein a size of the lower opening is greater than a size of the upper opening.
11. The display panel according to any preceding clause, a size of the second emission area of each of the plurality of first pixel areas is equal to or smaller than a size of the first emission area of a corresponding first pixel area of the plurality of first pixel areas.
12. The display panel according to any preceding clause, wherein the upper barrier pattern is configured by a touch electrode, and wherein the upper opening is configured by a space between the touch electrode.
13. The display panel according to any preceding clause, wherein each of the first emission area and the second emission area includes a first region overlapping with the upper barrier pattern and a second region overlapping with the plurality of upper openings, and
   wherein a length of the first region in a second direction perpendicular to the first direction is smaller than a length of the second region.
14. A vehicle, comprising the display panel according to any preceding clause.
15. The vehicle according to clause 14, wherein the display panel is disposed in front of a driver seat and a passenger seat arranged along the first direction.
16. The vehicle according to clause 15, wherein light emitted from the first emission area of each of the plurality of first pixel areas travels toward the driver seat by passing through the upper opening,
   wherein light emitted from the second emission area travels toward the passenger seat by passing through the upper opening, and
   wherein the light emitted from the first emission area toward the passenger seat and the light emitted from the second emission area toward the driver seat is blocked by the upper barrier pattern.

## Claims

1. A display panel, comprising:
a device substrate (100) including a plurality of first pixel areas (PA1);
an upper barrier pattern (520) disposed over the device substrate, the upper barrier pattern comprising a plurality of upper openings (520h),
wherein each of the plurality of first pixel areas includes a first emission area (EA1) and a second emission area (EA2) spaced from one another in a first direction,
wherein each of the first emission area and the second emission area included in a first pixel area of the plurality of first pixel areas partially overlaps an upper opening of the plurality of upper openings,
wherein each of the first emission area and the second emission area includes a first side and a second side each extending in a second direction perpendicular to the first direction, the second side being longer than the first side,
wherein the second side of the first emission area and the second side of the second emission area overlap with the upper opening, and
wherein the first side of the first emission area and the first side of the second emission area overlap with the upper barrier pattern.

2. The display panel according to claim 1, wherein the device substrate further comprises a plurality of second pixel areas (PA2), and wherein each of the plurality of second pixel areas includes one emission area.

3. The display panel according to claim 1 or claim 2, wherein the upper opening has a planar shape of a bar extending in the second direction.

4. The display panel according to any preceding claim, wherein each of the first emission area and the second emission area has a planar shape of a trapezoidal shape.

5. The display panel according to any preceding claim, wherein each of the plurality of first pixel areas is configured to display a specific color, and
wherein the first emission area and the second emission area included in the first pixel area are configured to realize a same color.

6. The display panel according to any preceding claim, wherein a light-emitting device of the first emission area and a light-emitting device of the second emission area are connected to separate driving circuits.

7. The display panel according to any preceding claim, wherein each of the plurality of first pixel areas further includes a non-emission area between the first emission area and the second emission area and overlaps with the upper opening, and
wherein each of the plurality of first pixel areas further includes a bank insulating layer disposed within the non-emission area.

8. The display panel according to any preceding claim, wherein each of the plurality of first pixel areas further includes a pixel lens (700) disposed on the upper barrier pattern and overlaps the upper opening, and
wherein a lens central point of the pixel lens is disposed between the first emission area and the second emission area.

9. The display panel according to claim 8, wherein the first emission area and the second emission area included in the first pixel area are configured to emit light through the upper opening and the pixel lens.

10. The display panel according to any preceding claim, further comprising:
a lower barrier pattern disposed between the device substrate and the upper barrier pattern, the lower barrier pattern including a lower opening,
wherein the lower opening overlaps the upper opening, and
wherein a size of the lower opening is greater than a size of the upper opening.

11. The display panel according to any preceding claim, a size of the second emission area of each of the plurality of first pixel areas is equal to or smaller than a size of the first emission area of a corresponding first pixel area of the plurality of first pixel areas.

12. The display panel according to any preceding claim, wherein the upper barrier pattern is configured by a touch electrode, and wherein the upper opening is configured by a space between the touch electrode.

13. The display panel according to any preceding claim, wherein each of the first emission area and the second emission area includes a first region overlapping with the upper barrier pattern and a second region overlapping with the plurality of upper openings, and
wherein a length of the first region in a second direction perpendicular to the first direction is smaller than a length of the second region.

14. A vehicle, comprising the display panel according to any preceding claim.

15. The vehicle according to claim 14, wherein the display panel is disposed in front of a driver seat and a passenger seat arranged along the first direction;
optionally wherein light emitted from the first emission area of each of the plurality of first pixel areas travels toward the driver seat by passing through the upper opening,
wherein light emitted from the second emission area travels toward the passenger seat by passing through the upper opening, and
wherein the light emitted from the first emission area toward the passenger seat and the light emitted from the second emission area toward the driver seat is blocked by the upper barrier pattern.
